# EUROPEAN PATENT APPLICATION

(11) **EP 2 091 074 A1**
(43) Date of publication of application: **19.08.2009**
(21) Application number: 08290533.2
(22) Date of filing: 10.06.2008
(51) Int. Cl.: H01L 21/306, H01L 21/762

(54) **Method for preparing hydrophobic surfaces**

(30) Priority: 13.02.2008 EP 08290138
(71) Applicant: S.O.I. TEC Silicon, 38190 Bernin (FR)
(72) Inventor: Peclard, Nicolas, 38420 Domene (FR); Radouane, Khalid, 38330 Montbonnot Saint Martin (FR); Gaudin, Gweltaz, 38000 Grenoble (FR); Radu, Ionut, 38920 Crolles (FR); Kerdiles, Sébastien, 38330 Saint Ismier (FR)
(74) Representative: Grünecker, Kinkeldey, Stockmair & Schwanhäusser Anwaltssozietät

(57) **Abstract**

The invention relates to a method for preparing hydrophobic surfaces which find their application in direct silicon bonding and strained material layer growth. The method comprises providing a substrate and subjecting the substrate to a mixed plasma treatment, wherein the mixed plasma comprises a reducing gas plasma, in particular H₂, and an inert gas plasma, in particular Ar and/or He.

## Description

The invention relates to a method for preparing a hydrophobic surface of a substrate which subsequently can undergo a bonding process or a process of growing a strained material layer on the hydrophobic surface.

A hydrophobic treatment of a substrate, like a Si wafer, is applied to limit the oxygen quantity on the surface of this substrate. After the a treatment, which also removes any native oxide present on the substrate, the surface of the substrate presents hydrogen terminated or dangling bonds and the growth of a native oxide can be suppressed. In contrast thereto, a hydrophilic surface essentially has OH terminated bonds and a native oxide is present. The typical way to determine whether a surface has hydrophobic or hydrophilic character is to measure the contact angle of a water drop on the surface. A contact angle of more than 30° indicates a hydrophobic surface.

A method to obtain hydrophobic surfaces is known in the art. The treatment consists of applying a fluoric acid (HF) to form a surface state which prevents the growth of a native oxide. To suppress remaining oxygen, the HF treatment is followed by an additional thermal treatment at high temperature (over 750°C) using hydrogen (H₂), which is also called a H₂ bake.

This standard method has, however, the problem that, in case one wants to bond two hydrophobic surfaces, e.g. in the Smart Cut^{™} process during which, prior to bonding, a predetermined splitting area is created inside one of the to be bonded substrates by ion implantation, only a low bonding energy can be achieved as no sufficiently high temperatures can be applied to remove the remaining oxygen on the surfaces of the to be bonded substrates. Actually, a high temperature treatment prior to bonding would not be suitable in this kind of process as the implanted ions would gather to bubbles which could lead to a premature detaching or blistering of the surface prior to bonding.

The hydrophobic treatment known in the art is also not suitable for the preparation of high quality strained epitaxial silicon layers. In such a fabrication process, the strained silicon layer is epitaxially grown on a hydrophobic surface. Due to the H₂ bake at high temperatures of the underlying substrate, defects occur on the hydrophobic surface which lead to threading dislocations in the strained silicon layer at high densities. Furthermore, oxygen residues present in the aqueous mixture used for the HF treatment lead to surface defects leading, for example, to the formation of so called watermarks. As typically the strained silicon layers epitaxially grown on these substrates should be rather thin (200A), these defects cannot be suppressed by growing the layers to a thickness at which the defects disappear.

It is therefore the object of the present invention to propose a hydrophobic surface treatment to prepare surfaces which will undergo bonding or on which strained layers, in particular strained silicon layers, can be formed.

This object is achieved with the method according to claim 1 but also with the method according to claim 6.

The inventive method for preparing a hydrophobic bonding surface comprises the steps of providing a substrate, in particular a silicon (110) or (100) wafer, subjecting the substrate to a mixed plasma treatment, wherein the mixed plasma treatment comprises a reducing gas plasma, in particular H₂, and an inert gas plasma, in particular argon and/or helium. Besides silicon, the substrate could also be one of silicon germanium (SiGe), germanium (Ge) or a III-V type semiconductor materials or Si02 on silicon with Si-H non polar termination.

The components of a mixed plasma fulfill the following roles. The reducing plasma leads to the etching of the native oxide on the surface of the substrate. The hydrogen is furthermore used to form the desired Si-H bonds at the surface. The dilution of the reducing plasma with inert gas plasma, in particular argon and/or helium, serves to limit the surface roughness of the substrate, to improve the uniformity of the treatment and also to assist the etching of the surface. It appeared that, for silicon wafers, optimized results have been achieved with a helium inert gas plasma which lead to improved and stable roughness values over the entire surface of the substrate after the treatment.

As a consequence of the inventive treatment, the H₂ bake at high temperature used in the prior art is not necessary any more, as oxygen present on the surface is removed by the plasma. In addition, if necessary it is also possible to suppress the HF treatment, as the mixed plasma can also remove the native oxide.

Advantageously, the method can further comprise a cleaning step prior to the plasma treatment. A cleaning process prior to the application of the mixed plasma accentuates the advantageous effects achieved with the mixed plasma.

Advantageously, the cleaning step can be at least one of a hydrophilic and hydrophobic cleaning. The hydrophobic cleaning, e.g. the already mentioned HF treatment already reduces at least partially the native oxide present on the surface of the substrate. A hydrophilic cleaning, for example a RCA, SC1, SC2 treatment, keeps the native oxide on the surface of the substrate but provides a better starting point for the plasma treatment which, in the end, leads to improved and stable results.

The invention also relates to a method for preparing a direct silicon bonding (DSB) substrate comprising providing a first substrate, in particular a silicon (110) wafer prepared as described above, providing a second substrate, in particular a silicon (100) wafer prepared as described above and attaching, preferably by bonding, the first substrate to the second substrate. With the inventive surface preparation of the first and second substrates, a bonding energy in the range of 4 - 20 mJ/m² is achieved without having to carry out a high temperature treatment. The attachment step can be further optimized by applying an annealing step at temperatures going up to 400°C.

Advantageously, the method can further comprise a step of providing a predetermined splitting area inside the first or second substrate prior to attaching and detaching at the predetermined splitting area to transfer a layer of the first or second substrate onto the second or first substrate respectively. As already mentioned above, the inventive method of applying a mixed plasma enables a surface preparation at low temperatures so that the above described Smart Cut^{™} technology can be advantageously applied to direct silicon bonding structures.

The object of the invention is also achieved with the method according to claim 6 relating to a method for preparing a strained material layer, in particular a strained silicon layer, over a base substrate and comprising the steps of providing a base substrate, in particular a silicon substrate, providing a graded layer, in particular silicon germanium and/or a buffer layer, in particular a silicon germanium buffer layer or a germanium buffer layer characterised in further comprising a mixed plasma treatment of the graded layer and/or the buffer layer, wherein the mixed plasma comprises a reducing gas plasma, in particular hydrogen and an inert gas plasma, in particular argon and/or helium.

In this context, a graded silicon germanium layer relates to a layer in which the amount of germanium rises from about 0% at the interface towards the base substrate, typically silicon, to about 20 - 50% of germanium at the interface towards the strained layer or the silicon germanium buffer layer. Like already described above, with the mixed plasma, a hydrophobic surface on the graded silicon germanium layer or the silicon germanium buffer layer if present, can be achieved using the reducing gas plasma, while at the same time the amount of defects, like threading dislocations, can be kept low due to the inert gas plasma of the mixed plasma. Thus, the H₂ bake at high temperature like necessary in the prior art is no longer necessary.

Preferably, the method can furthermore comprise an oxygen containing layer removing step, in particular an HF cleaning step, prior to applying the mixed plasma. Combining both a wet and a dry treatment leads further improved silicon germanium surfaces.

Advantageously, the method can further comprise providing the strained silicon, in particular by epitaxial growth, over the mixed plasma treated silicon germanium surface of the silicon germanium layer or the silicon germanium buffer layer if present. With the improved surface quality of the silicon germanium layer, e.g. reduced watermarks and a reduced threading dislocation density, a thin strained silicon layer with a thickness of less than 200 A can be provided with in turn improved crystalline qualities compared to the strained silicon layers prepared with methods known in the art.

According to a preferred variant, the method can furthermore comprise the steps of providing a predetermined splitting area inside the strained silicon layer or the buffer layer or the graded silicon germanium layer, attaching, preferably by bonding, the strained silicon layer to a handle substrate, in particular a silicon wafer with a dielectric layer, detaching at the predetermined splitting area to at least transfer a part of the strained silicon layer onto the handle substrate to thereby form a strained silicon on insulator substrate, and subjecting the strained silicon on insulator substrate to a mixed plasma treatment wherein the mixed plasma comprises a reducing gas plasma, in particular H₂, and an inert gas plasma, in particular argon and/or helium. When a at least a part of the buffer layer or the buffer layer and part of the graded silicon germanium layer are transferred together with the strained silicon layer, they can be removed using a HF cleaning, etching or the mixed plasma.

To obtain a strained silicon layer surface with the desired improved surface properties on the strained silicon on insulator substrate, the mixed plasma is thus again applied so that the same advantageous effects, like already described above with respect to the underlying silicon germanium buffer layer or graded silicon germanium layer, can be achieved.

Preferably, this method can furthermore comprise a step of forming a thicker strained silicon layer by epitaxial growth starting from the transferred strained silicon layer. As the mixed plasma treated strained silicon surface has reduced watermarks and/or threading dislocation density, a thick strained silicon layer can be provided with improved crystalline qualities.

Advantageously, any one of the methods described above can be carried out at temperatures of less than 400°C, at least for the steps prior to bonding. In this temperature range, the above-described Smart Cut^{™} type technology can advantageously be applied without negative impacts on the predetermined splitting area.

Preferably, the mixed plasma treatment can be carried out at pressures between 1 - 100 mTorr and at powers of 100 Watt up to 300 Watt in a plasma chamber with the gases being introduced with flow rates going from 100 - 1000 sccm. Under these conditions, an extensive ionic bombardment of the surface can be prevented to avoid the deterioration of the surface roughness while, at the same time, the removal of oxygen is achieved.

Preferably, the mixed plasma is composed of 30 - 70% of reducing gas plasma.

Embodiments of the invention will be described in detail, together with their advantages, in relation with the enclosed Figures:
- Figs 1A - 1G: illustrate a first inventive embodiment dealing with a method for preparing hydrophobic bonding surfaces,
- Figs 2A - 2C: illustrate a second inventive embodiment of preparing a hydrophobic surface for the subsequent growth of a stained material layer, and
- Figs 3A - 3G: illustrate a third inventive embodiment dealing with a method for fabricating a strained silicon on insulator substrate.

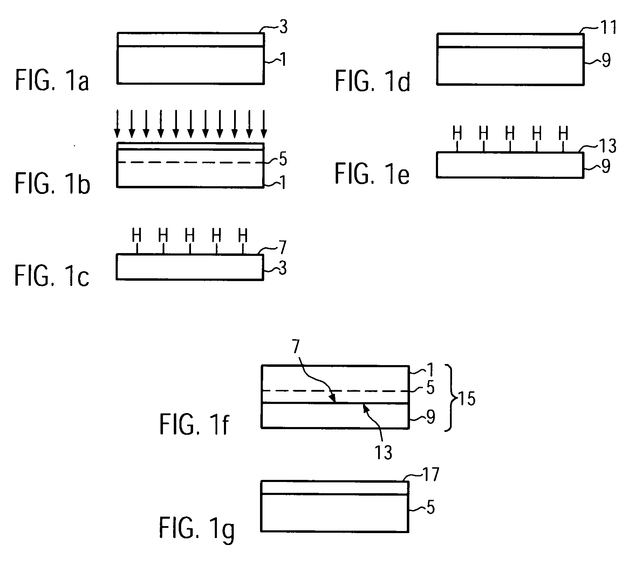

Figures 1A - 1G illustrate a first embodiment of the invention dealing with a method for preparing a direct silicon bonding substrate (DSB). Instead of silicon other materials like silicon germanium (SiGe), germanium (Ge) or a III-V type semiconductor materials or Si02 on silicon with Si-H non polar termination could, however, also find their application according to the invention. During this fabrication method, the inventive method for preparing a hydrophobic bonding surface according to claim 1, finds its application.

Figure 1A illustrates a first substrate 1, in this example a silicon (110) wafer, with a native silicon oxide layer 3 on it. Subsequently, like illustrated in Figure 1B, ions, for example hydrogen or helium ions, are implanted into the substrate 1 to form a predetermined splitting area 5 essentially parallel to the main surface of the substrate 1.

The substrate 1 with its native oxide layer 3 is then subjected to a mixed plasma treatment, according to the invention and the result is illustrated in Figure 1B. The mixed plasma comprises a reducing gas plasma, in particular based on hydrogen, and an inert gas plasma, for example argon, helium or a combination thereof. The treatment process is applied with a pressure of around 1 - 100 mTorr and the power applied in the plasma chamber where the process is carried out is around from 100 Watt to 300 Watt in case of a 300 mm wafer. Typically, the hydrogen content in the gas mixture represents 30% to 70%.

As a consequence of this mixed plasma treatment, the native oxide layer 3 is removed and a hydrophobic surface 7 is achieved. This means that the surface 7 of substrate 1 is terminated with hydrogen or represents dangling bonds or a combination thereof.

Figure 1D illustrates a second substrate 9, here silicon (100), also with a native oxide layer 11 over it.

The second substrate 9 is subjected to the same mixed plasma treatment like the first substrate 1. This treatment leads to a hydrophobic surface 13 on the second substrate 7, without native oxide. This situation is illustrated in Figure 1E.

Wafers 1 and 9 are then attached, preferably by bonding, to each other to form a source handle compound 15 built up of the second substrate 9 and the first substrate 1 with the predetermined splitting area 5. Attachment occurs at the hydrophobic surfaces 7 and 13 of the first and second substrates 1 and 9.

Afterwards, an optional annealing step at temperatures ranging from 150°C up to 400°C can be carried out to strengthen the bonding between the two substrates.

Subsequently, the source handle compound 15 undergoes a heat treatment during which the implanted ions in the predetermined splitting area 5 gather to form bubbles and finally, a detachment at the predetermined splitting area 5 occurs such that a layer 17 of the first substrate 1 is transferred onto the second substrate 7, like illustrated in figure 1g.

Via this method, a direct silicon bonded substrate 19 is created in which a silicon layer 13 of one crystalline orientation, here silicon (110) is bonded to a silicon substrate with a different crystalline orientation, here silicon (100). No dielectric layer is present between the two parts of the DSB substrate 19.

According to variants of the described method, between the steps illustrated in Figs. 1A and 1C, an additional cleaning step could be applied. According to one possibility, a hydrophobic cleaning using a wet HF treatment could be applied which could already remove the native oxide 3 so that the mixed plasma treatment will essentially have the role to remove remaining oxygen to create the desired hydrophobic surface properties. According to a second possibility, a hydrophilic type cleaning, e.g. applying RCA, SC1 or SC2 treatment, could be applied. In this case, the native oxide layer 3 would remain.

With the described method, the following advantages can be achieved. Due to the fact that it is no longer necessary to carry out a high temperature H2 bake in order to obtain a hydrophobic surface and which was mandatory in the prior art, it becomes now possible to apply the described SmartCut^{™} process not only to silicon on insulator type wafers but also in the case of direct silicon bonding.

In fact, the high temperature H₂ bake known in the art cannot be applied as, at temperatures of around 800°C, the predetermined splitting area 5 would be weakened so much that the process cannot be carried out. With a H₂ bake at lower temperatures, one does not achieve the necessary bonding energies to obtain a stable DSB substrate. In contrast thereto, using the inventive application of the mixed plasma, the whole process prior to bonding can be carried out at low temperatures, in particular at temperatures of less than 400°C, and sufficient bonding energies in the range of about 4 - 20 mJ/m² are obtained. Typically, the mixed plasma is carried out at a temperature between room temperature and 150°C.

The mixed plasma treatment has the following effects. The reducing gas plasma, i.e. in this example the hydrogen plasma, leads to the etching of the native oxide but also to the formation of the desired silicon hydrogen bonds at the surface. With the mentioned process parameters, an ionic bombardment of the surface is prevented which avoids a deterioration of the surface roughness. By diluting the hydrogen plasma with an inert gas, the surface properties of the treated substrate are further improved. In addition, the inert gas helps in providing a uniform treatment over the entire surface and finally, also assists the etching of the surface. Thus, a surface state 7, 13 is achieved which becomes suitable for hydrophobic bonding.

Concerning surface roughness, best results, in particular concerning uniformity, have been achieved using helium as inert gas.

In the embodiment described above, ion implantation occurred in a silicon (110) wafer but, of course, it is also possible to carry out the ion implantation into wafer 5 having a (100) surface.

In an practical example, by applying a helium hydrogen mixed plasma (with 30% helium) at a power of 250 Watts and a pressure of 50 mTorr for 10 seconds, a hydrophobic surface was achieved (contact angle measurement 75.1 degrees) with a uniform surface roughness of 1.5 A and a haze of 0.51 on a silicon (110) wafer. For a mixed plasma having 50% argon and hydrogen at 250 Watts, 50 mTorr and 10 seconds, a contact angle of 73.4 degrees was measured with a haze of 0.3 and a roughness from 1.2 - 1.9 A.

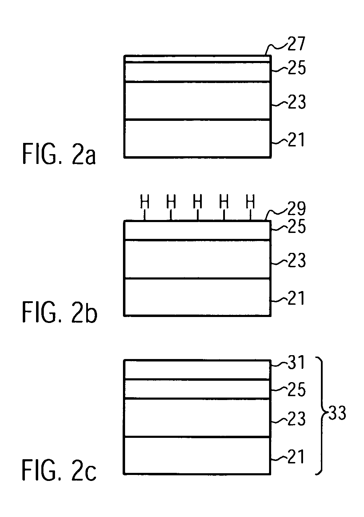

Figure 2 illustrates a second embodiment of the invention and deals with the preparing of a strained material layer over a base substrate. In this embodiment, the strained material is silicon. However, the invention could also be applied to other materials, e.g. silicon germanium or germanium or III-V semiconductor materials. The term "strained" indicates that, in the strained layer, the lattice constants do not correspond to the ones of the material in a free configuration. Strained materials show interesting properties, for example an increase in electron mobility.

To fabricate strained silicon, one starts with a base substrate 21, here a silicon wafer. Then a graded silicon germanium layer 23 is provided over the base layer 21. This graded silicon germanium layer 23 has its germanium content growing from the interface towards the base substrate 21 to the other surface side. Typically, at the interface with the base substrate 21, one starts with 0% germanium and at the opposite side a content of about 20 - 50% germanium is achieved. By doing so, through the thickness of layer 23, the lattice constant changes. Usually, a further silicon germanium buffer layer 25 with the same or at least similar germanium content like at the interface is provided over the graded layer 23. Nevertheless the invention is not limited to this type of graded layer and/or buffer layer. This structure is terminated with a native oxide layer 27, like illustrated in Figure 2a.

To be able to grow an epitaxial strained silicon layer, the native oxide layer 27 needs to be removed first. According to the invention, this is achieved by applying a mixed plasma like already described in detail above in connection with preparing bonding surfaces. The description of the mixed plasma is therefore not repeated again, but is incorporated herewith by reference with respect to Figures 1A to 1G. As a result of the mixed plasma treatment, the oxide layer 27 is removed and the surface 29 of the buffer layer 27 has been turned into a hydrophobic surface having hydrogen terminated or dangling bonds, like illustrated in Figure 2B.

Surface 29 then serves at the starting point for an epitaxial growth of the strained material layer 31 to form a strained silicon comprising substrate 33, like illustrated in Figure 2C. Compared to the prior art method using a HF treatment followed by a H₂ bake at 800°C, the density of threading dislocations present at the surface of the buffer layer 25 is lower. Furthermore, the negative effects of watermarks due to remaining oxygen is also reduced. As a consequence, a high quality strained silicon layer 31, which can be grown at rather low thicknesses of about 200A, can be provided.

According to a variant, prior to applying the mixed plasma, it is possible to carry out a cleaning step to remove the native oxide 27, in particular using a HF treatment.

Like in the first embodiment, these steps can be carried out at low temperatures, in particular at less than 500°C.

Like already mentioned above, the strained silicon layer 31 could also be provided directly on the graded layer after having carried out the inventive mixed plasma treatment.

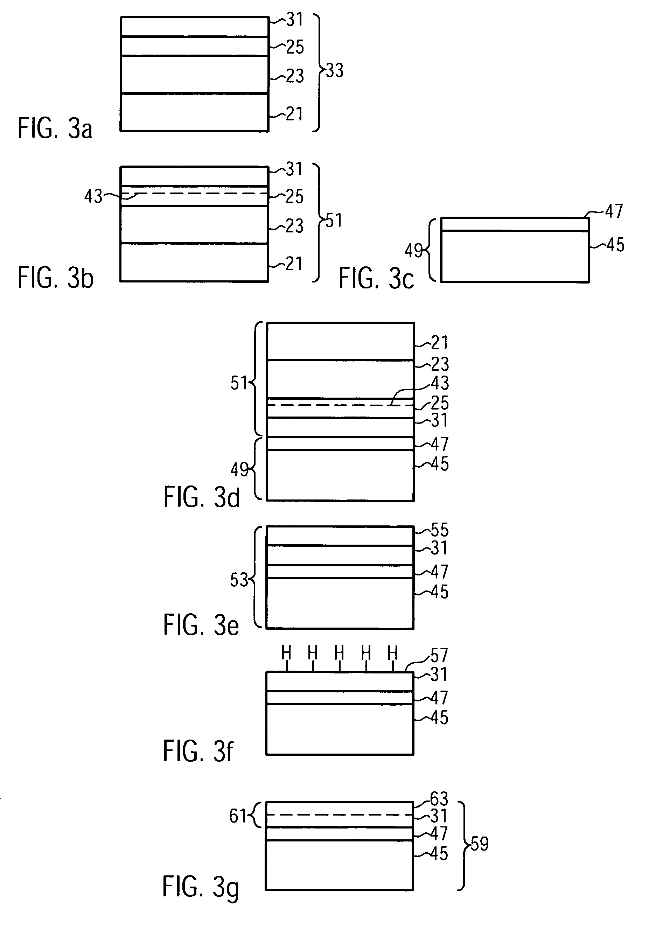

Figures 3A - 3G illustrate a third inventive embodiment. This embodiment deals with the fabrication of a strained silicon on insulator substrate.

Figure 3A recalls the strained silicon comprising substrate illustrated 33 of Figure 2C of the second embodiment, thus comprising the base substrate 21, the graded silicon germanium layer 23, the buffer silicon germanium layer 25 and the strained silicon layer 31.

This structure 33 is then subjected to a step of providing a predetermined splitting area 43, the result of which is illustrated in Figure 3B. The properties of the process step for creating the predetermined splitting area are described in detail with respect to Figure 1B, the description thereof is incorporated herewith by reference. Figure 3B illustrates that predetermined splitting area 43 is inside the buffer layer 25. According to variants, it could also be inside the graded layer 23 itself or even inside the strained silicon layer 31 or at one of the interfaces between these layers.

Furthermore, a substrate 45 with a dielectric layer 47, for example a silicon wafer with a native silicon dioxide on top, forming a handle substrate 49 is provided (see Figure 3C). Figure 3D illustrates the result of attaching, in particular by bonding, the handle substrate 4 to the source substrate 51. Attachment occurs at the strained silicon layer 31 and the surface of the dielectric layer 47. According to variants a dielectric layer could be present on the strained silicon layer 31 and/or substrate 45 could be bare silicon without dielectric layer.

Following a heat treatment, detachment occurs at the predetermined splitting area 43 and a first strained silicon on insulator substrate 53, illustrated in Figure 3E, is obtained. This substrate 53 comprises a remainder of the buffer layer 55, the strained silicon layer 31, the dielectric layer 47 and the handle substrate 45.

According to the invention, the first strained silicon on insulator substrate 53 is then subjected to the same mixed plasma treatment as already described in the second embodiment to remove the remainder of the buffer layer 55 and to create a hydrophobic surface 57 on the strained silicon layer 31. Of course, the removal of the remainder of the buffer layer 55 can also be achieved with a wet HF treatment.

Finally, the strained silicon layer 31 with its hydrophobic surface 57 can serve as the starting point of a regrowth process step to achieve a thicker strained silicon layer with more than 200 A under optimized conditions. Thus, in the end, see Figure 3G, a strained silicon on insulator substrate 55 is obtained comprising a thick strained silicon layer 61 composed of the transferred strained silicon layer 31 and the newly epitaxially grown strained silicon 63 provided on the dielectric layer 47 and the silicon wafer 45 of the handle substrate 49.

Thus, in this embodiment, the inventive mixed plasma treatment is carried out twice, first of all to obtain a strained silicon layer with reduced threading dislocation densities and less defects due to watermarks and second, the surface of the strained silicon layer, which has been transferred onto the handle substrate, is subjected to the mixed plasma to serve as a starting point of regrowth of the strained silicon layer to achieve a thick strained silicon on insulator substrate with in turn also reduced threading dislocation density.

## Claims

1. Method for preparing a hydrophobic bonding surface comprising the steps of:
- providing a substrate, in particular a Si (110) or (100) wafer, and
- subjecting the substrate to a mixed plasma treatment,
wherein the mixed plasma comprises a reducing gas plasma, in particular H₂, and an inert gas plasma, in particular Ar and/or He.

2. Method according to claim 1, further comprising a cleaning step prior to the plasma treatment.

3. Method according to claim 2, wherein the cleaning step is at least one of a hydrophilic and hydrophobic cleaning.

4. Method for preparing a direct silicon bonding (DSB) substrate comprising:
- providing a first substrate, in particular a Si (110) wafer, prepared according to one of claims 1 to 3,
- providing a second substrate, in particular a Si (100) wafer, prepared according to one of claims 1 to 3,
- attaching, preferably by bonding, the first substrate to the second substrate.

5. Method according to claim 4, further comprising a step of:
- providing a predetermined splitting area inside the first or second substrate prior to attaching, and
- detaching at the predetermined splitting area to transfer a layer of the first or second substrate onto the second or first substrate respectively.

6. Method for preparing a strained material layer, in particular a strained silicon layer or strained SiGe layer, over a base substrate comprising the steps of:
- providing a base substrate, in particular a Si or a Silicon On Insulator, or a strained silicon on insulator substrate,
- providing a graded layer, in particular a graded SiGe layer and/or a buffer layer, in particular a SiGe buffer layer,
**characterized in** further comprising a mixed plasma treatment of the graded layer and/or the buffer layer, wherein the mixed plasma comprises a reducing gas plasma, in particular H₂, and an inert gas plasma, in particular Ar and/or He.

7. Method according to claim 6, further comprising a oxygen containing layer removing step, in particular a HF cleaning step prior to applying the mixed plasma.

8. Method according to claim 6 or 7 further comprising providing the strained silicon layer, in particular by epitaxial growth, over the mixed plasma treated surface of the graded layer of the buffer layer.

9. Method according to claim 8, further comprising the steps of:
- providing a predetermined splitting area inside the strained silicon layer or the buffer layer or the graded SiGe layer,
- attaching, preferably by bonding the strained silicon layer to a handle substrate, in particular a Si wafer with a dielectric layer,
- detaching at the predetermined splitting area to at least transfer a part of the strained silicon layer onto the handle substrate to thereby form a strained silicon on insulator substrate, and
subjecting the strained silicon on insulator substrate to a mixed plasma treatment wherein the mixed plasma comprises a reducing gas plasma, in particular H₂, and an inert gas plasma, in particular Ar and/or He.

10. Method according to claim 9, further comprising a step of forming a thicker stained silicon layer by epitaxial growth starting from the transferred strained silicon layer.

11. Method according to one of claims 1 to 10, wherein the temperature prior to bonding is less than 400°C.

12. Method according to one of claims 1 to 11, wherein the mixed plasma is applied at a pressure between 1 mTorr to 100 mTorr and/or at a power of 100 W to 300 W and/or at flow rates of 100 to 1000 sccm.

13. Method according to one of claims 1 to 12, wherein the reducing gas plasma represents 30 to 70% of the mixed plasma.
